# EUROPEAN PATENT APPLICATION

(11) **EP 4 365 881 A1**
(43) Date of publication of application: **08.05.2024**
(21) Application number: 23207564.8
(22) Date of filing: 02.11.2023
(51) Int. Cl.: G09G 3/3233, G09G 3/3275, G09G 3/3291

(54) **DISPLAY DEVICE**

(30) Priority: 03.11.2022 KR 20220145437
(71) Applicant: Samsung Display Co., Ltd., Yongin-si, Gyeonggi-do 17113 (KR)
(72) Inventor: CHUN, Byung Ki, 17113 Yongin-si (KR); KA, Ji Hyun, 17113 Yongin-si (KR); BAE, Min Seok, 17113 Yongin-si (KR); IM, Chang Bin, 17113 Yongin-si (KR); HYUN, Chae Han, 17113 Yongin-si (KR)
(74) Representative: Taor, Simon Edward William

(57) **Abstract**

A display device includes a display panel including a pixel and a sensor pixel, the pixel including a light emitting element and a driving transistor controlling a current flowing through the light emitting element, the sensor pixel including sensor transistors, a data driver that supplies a data signal to the pixel through a data line and provides a sensor data signal to the sensor pixel through a sensor data line, and a sensing driver that obtains sensing information on a current flowing through the sensor pixel. The sensor transistors are electrically connected in parallel to each other and are commonly electrically connected to the sensor data line. The sensor transistors and the driving transistor include a substantially same characteristic.

## Description

### CROSS-REFERENCE TO RELATED APPLICATION(S)

This application claims priority to and benefits of Korean Patent Application No. 10-2022-0145437, filed on November 03, 2022 in the Korean Intellectual Property Office.

### BACKGROUND

### 1. Technical Field

The disclosure relates to a display device.

### 2. Description of the Related Art

A display device displays an image using a pixel including a light emitting element. A pixel may be deteriorated due to use, and the deteriorated pixel may not emit light with a desired luminance.

The display device may calculate a lifespan (or a deterioration amount) of the pixel by calculating a luminance amount totally emitted by the pixel, and compensate for data (for example, a grayscale value) based on the calculated lifespan, and the pixel (or the light emitting element) may emit light with a desired luminance based on the compensated data.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

An aspect of the disclosure provides a display device capable of more accurately compensating for deterioration of a pixel.

Aspects of the disclosure are not limited to the aspect described above, and other technical aspects which are not described will be clearly understood by those skilled in the art from the following description.

According to an embodiment, a display device may include a display panel including a pixel and a sensor pixel, the pixel including a light emitting element and a driving transistor controlling a current flowing through the light emitting element, the sensor pixel including sensor transistors, a data driver that supplies a data signal to the pixel through a data line and provides a sensor data signal to the sensor pixel through a sensor data line, and a sensing driver that obtains sensing information on a current flowing through the sensor pixel. The sensor transistors may be electrically connected in parallel to each other and may be commonly electrically connected to the sensor data line. The sensor transistors and the driving transistor may include a substantially same characteristic.

The sensor transistors and the driving transistor may include a same semiconductor material, and the sensor transistors and the driving transistor may include a same structure and shape.

The sensor pixel may not include a light emitting element.

The sensor pixel may include at least three sensor transistors.

The sensor pixel may be electrically connected between a first power line and a second power line, and the sensing driver may measure a voltage between both ends of a resistor electrically connected to the sensor pixel in series between the first power line and the second power line.

The display device may further include a timing controller that predicts a deterioration characteristic of the pixel based on the sensing information and compensates for image data based on the predicted deterioration characteristic of the pixel, and the data driver may generate the data signal based on the compensated image data.

The data driver may include a plurality of data integrated circuits mounted on the display panel, and in a plan view, the sensor pixel may be positioned between two adjacent ones among the plurality of data integrated circuits in an arrangement direction of the plurality of data integrated circuits.

The data driver may continuously provide the sensor data signal of a voltage level corresponding to a maximum grayscale to the sensor data line during a driving period, and provide the sensor data signal of a voltage level corresponding to a grayscale within a grayscale range to the sensor data line during a sensing period.

The display panel may further include a reference pixel, the reference pixel and the sensor pixel may include a substantially same characteristic, and the data driver may provide a reference data signal of a voltage level different from that of the sensor data signal to the reference pixel during the driving period, and may provide a reference data signal of a voltage level equal to that of the sensor data signal to the reference pixel during the sensing period.

The reference data signal in the driving period may have a gate-off voltage level substantially turning off a transistor.

The sensing driver may measure a current flowing through the reference pixel and obtain the sensing information corresponding to a difference between the current of the sensor pixel and the current of the reference pixel.

The display panel may include a first pixel, a second pixel, a first sensor pixel, and a second sensor pixel. The first pixel and the second pixel may emit different color light. The data driver may provide a first maximum data voltage of the first pixel to the first sensor pixel and provide a second maximum data voltage of the second pixel to the second sensor pixel during a driving period, and the second maximum data voltage may be different from the first maximum data voltage.

The sensor pixel may further include auxiliary transistors electrically connected to the sensor transistors in series, respectively, and gate electrodes of the auxiliary transistors may be commonly electrically connected to a sensor control line.

The display device may further include a timing controller that predicts a deterioration characteristic of the pixel based on the sensing information and compensates for image data based on the predicted deterioration characteristic of the pixel, the data driver may generate the data signal based on the compensated image data, and the timing controller may provide a sensor control signal to the sensor control line.

According to an embodiment, a display device may include a display panel including a pixel and a sensor pixel, the pixel including a light emitting element and a driving transistor controlling a current flowing through the light emitting element, the sensor pixel including a sensor transistor, a data driver that supplies a data signal to the pixel through a data line and provides a sensor data signal to the sensor pixel through a sensor data line, and a sensing driver that obtains sensing information on a current flowing through the sensor pixel. The sensor transistor and the driving transistor may include a substantially same characteristic. The sensor pixel may not include a light emitting element.

The sensor pixel may be electrically connected between a first power line and a second power line, and the sensing driver may measure a voltage between both ends of a resistor electrically connected to the sensor pixel in series between the first power line and the second power line.

The data driver may continuously provide the sensor data signal of a voltage level corresponding to a maximum grayscale to the sensor data line during a driving period, and may provide the sensor data signal of a voltage level corresponding to a grayscale within a grayscale range to the sensor data line during a sensing period.

The display panel may further include a reference pixel, the reference pixel and the sensor pixel may include a substantially same characteristic, and the data driver may provide a reference data signal of a voltage level different from that of the sensor data signal to the reference pixel during the driving period, and may provide a reference data signal of a voltage level equal to that of the sensor data signal to the reference pixel during the sensing period.

The reference data signal in the driving period may have a gate-off voltage level substantially turning off a transistor.

The sensing driver may measure a current flowing through the reference pixel and obtain the sensing information corresponding to a difference between the current of the sensor pixel and the current of the reference pixel.

According to an aspect, there is provided a display device as set out in claim 1. Additional features are set out in claims 2 to 11. According to an aspect, there is provided a display device as set out in claim 12. Additional features are set out in claims 13 to 15.

Details of other embodiments are included in the detailed description and drawings.

In the display device according to embodiments, the sensor pixel may not include a light emitting element (or a simulated light emitting element) and may include multiple sensor transistors substantially the same as a driving transistor of the pixel. The sensing driver may more accurately and directly sense only a characteristic of the sensor transistor. Therefore, a sensing error due to deterioration of the light emitting element (or the simulated light emitting element) and indirect current sensing (for example, current integration) may be excluded, sensing accuracy may be improved, and deterioration of the pixel may be more accurately compensated.

An effect according to embodiments is not limited by the examples above, and additional effects are included in the present specification.

### BRIEF DESCRIPTION OF THE DRAWINGS

The above and other features of the disclosure will become more apparent by describing in further detail embodiments thereof with reference to the accompanying drawings, in which:
FIG. 1 is a schematic block diagram illustrating a display device according to embodiments of the disclosure;
FIG. 2 is a schematic circuit diagram illustrating an embodiment of a pixel included in the display device of FIG. 1;
FIG. 3 is a schematic waveform diagram illustrating an embodiment of an operation of the pixel of FIG. 2;
FIG. 4 is a schematic circuit diagram illustrating an embodiment of a sensor pixel and a sensing driver included in the display device of FIG. 1;
FIG. 5 is a schematic waveform diagram illustrating an embodiment of an operation of the sensor pixel and the sensing driver of FIG. 4;
FIG. 6 is a schematic circuit diagram illustrating a comparative example of the sensor pixel and the sensing driver;
FIG. 7 is a schematic diagram illustrating currents measured in the sensor pixel of FIG. 6 and a pixel of FIG. 2;
FIGS. 8A and 8B are schematic plan views illustrating an embodiment of the display device of FIG. 1;
FIG. 9 is an enlarged schematic plan view of a portion of a display panel of FIG. 8A;
FIG. 10A is a schematic waveform diagram illustrating an embodiment of signals provided to sensor pixels of FIGS. 8A and 8B;
FIG. 10B is a schematic waveform diagram illustrating an embodiment of signals provided to a first sensor pixel and a first reference pixel of FIGS. 8A and 8B;
FIG. 11 is a schematic diagram illustrating an embodiment of a sensing driver of FIGS. 8A and 8B;
FIG. 12 is a schematic block diagram illustrating an embodiment of the display device of FIG. 1; and
FIGS. 13A and 13B are schematic circuit diagrams illustrating an embodiment of a sensor pixel and a sensing driver included in the display device of FIG. 12.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

Some embodiments are described in the accompanying drawings in relation to functional blocks, units, and/or modules. Those skilled in the art will understand that such blocks, units, and/or modules can be physically implemented by a logic circuit, an individual component, a microprocessor, a hard wire circuit, a memory element, a line connection, and other electronic circuits. These may be formed using a semiconductor-based manufacturing technique or other manufacturing techniques. A block, unit, and/or module implemented by a microprocessor or other similar hardware may be programmed and controlled using software to perform various functions discussed herein, and optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, a block, unit, and/or module may be physically separated into two or more interacting individual blocks, units, and/or modules without departing from the scope of the disclosure. In addition, in some embodiments, blocks, units, and/or modules may be physically combined into more complex blocks, units, and/or modules without departing from the scope of the disclosure.

It will be understood that the terms "connected to" or "coupled to" may include a physical and/or electrical connection or coupling.

Although "first," "second," and the like are used to describe various components, these components are not limited by these terms. These terms are used only to distinguish one component from another component. Therefore, a first component described below may be a second component within the disclosure.

In the drawings, some components which are not directly related to a characteristic of the disclosure may be omitted to clearly represent the disclosure. In addition, some components in the drawings may be shown with an exaggerated, size, ratio, or the like. Throughout the drawings, the same or similar components will be given by the same reference numerals and symbols as much as possible even though they are shown in different drawings, and repetitive descriptions will be omitted.

The term "substantially" as used in this disclosure can include the meanings of completely, almost completely, or to any significant degree in some applications and in accordance with the understanding of those skilled in the art.

Unless otherwise defined, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

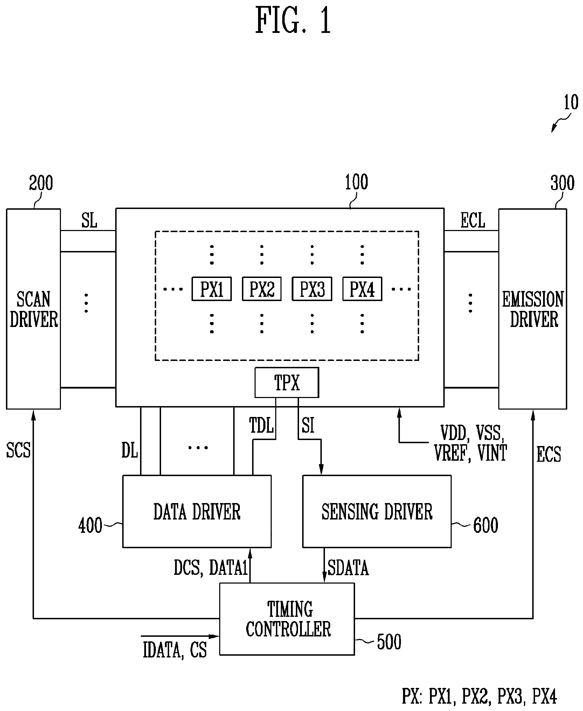

FIG. 1 is a schematic block diagram illustrating a display device according to embodiments of the disclosure.

In case that the display device is an electronic device in which a display surface is applied to at least one surface, such as a smartphone, a television, a tablet PC, a mobile phone, a video phone, an e-book reader, a desktop PC, a laptop PC, a netbook computer, a workstation, a server, a PDA, a portable multimedia player (PMP), an MP3 player, a medical device, a camera, or a wearable, the disclosure may be applied.

Referring to FIG. 1, the display device 10 may include a display panel 100, a scan driver 200 (or a gate driver), an emission driver 300, a data driver 400 (or a source driver), a timing controller 500 (or a processor), and a sensing driver 600 (or a sensing unit). In FIG. 1, the sensing driver 600 is shown separately from the timing controller 500, but the sensing driver 600 may be integrated with the timing controller 500 according to an embodiment. According to an embodiment, the sensing driver 600 may be integrated with the data driver 400.

The display device 10 may be implemented as an organic light emitting display device including an organic light emitting element. However, the display device 10 of embodiments is not limited thereto, and, for example, the display device 10 may be implemented as an inorganic light emitting display device including an inorganic light emitting element (for example, an inorganic light emitting element having a nano scale to micro scale of size), a liquid crystal display device (LCD), an electrophoretic display (EPD), or the like. In addition, the display device 10 may be implemented as a flexible display device, a rollable display device, a curved display device, a transparent display device, a mirror display device, or the like.

The display panel 100 may display an image. The display panel 100 may include pixels PX.

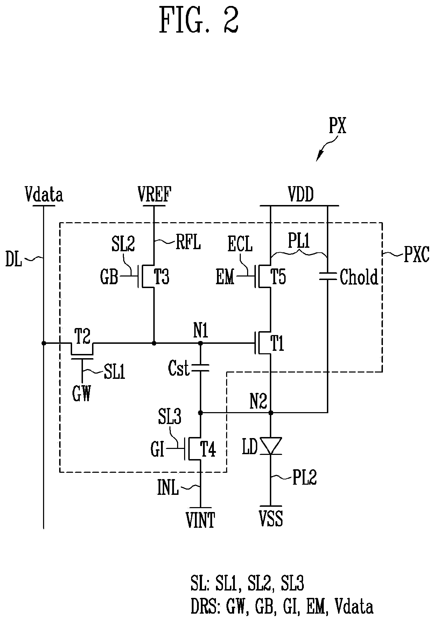

The pixels PX may be disposed in a display area of the display panel 100. The display area may be an area where the pixel PX are provided to display an image. A pixel PX may be connected to a scan line SL, an emission control line ECL, and a data line DL. The pixel PX may emit light with a luminance corresponding to a data signal (or a data voltage) of the data line DL in response to a scan signal of the scan line SL and an emission control signal of the emission control line ECL. A detailed configuration of the pixel PX is described later with reference to FIG. 2.

In an embodiment, a pixel PX (or the display panel 100) may include pixels PX1 to PX4 (or sub-pixels). For example, the pixel PX may include a first pixel PX1, a second pixel PX2, a third pixel PX3, and a fourth pixel PX4.

Each of the pixels PX1 to PX4 may emit light of a predetermined or selected color. According to an embodiment, at least a portion of the pixels PX1 to PX4 may emit light of different colors. For example, the first pixel PX1 may emit light of a first color, the second pixel PX2 may emit light of a second color, and the third pixel PX3 may emit light of a third color. The fourth pixel PX4 may emit the light of the second color, but embodiments of the disclosure are not limited thereto, and the fourth pixel PX4 may emit light of a fourth color. For example, the first pixel PX1 may be a red pixel emitting red light, the second pixel PX2 may be a green pixel emitting green light, the third pixel PX3 may be a blue pixel emitting blue light, and the fourth pixel PX4 may be a green pixel emitting green light or a white pixel emitting white light, but embodiments of the disclosure are not limited thereto.

The pixels PX1 to PX4 may be regularly arranged according to a stripe or a PenTile^{®} arrangement structure. For example, the first, second, third, and fourth pixels PX1, PX2, PX3, and PX4 may be sequentially and repeatedly disposed in a horizontal direction, and may also be repeatedly disposed in a vertical direction. At least one of the first, second, third, and fourth pixels PX1, PX2, PX3, and PX4 disposed adjacent to each other may configure one unit pixel capable of emitting light of various colors. However, an arrangement structure of the pixels PX1 to PX4 is not limited thereto, and the pixels PX1 to PX4 may be arranged on the display panel 100 in various structures and/or methods.

In embodiments, the display panel 100 may further include a sensor pixel TPX (or a sensing pixel).

The sensor pixel TPX may be disposed in a non-display area of the display panel 100. The non-display area may be an area except for the display area, and an image may not be displayed in the non-display area.

The sensor pixel TPX may be connected to a sensor data line TDL (or a test data line). For example, the sensor pixel TPX may include a transistor that operates in response to a sensor data signal (or a test data signal) of the sensor data line TDL. The transistor may be deteriorated as an operation time elapses, and a magnitude of a current flowing through the transistor may differ from a magnitude of an ideal current. For example, as the transistor is deteriorated, the magnitude of the current may decrease. The sensing driver 600 to be described later may obtain sensing information SI (or a sensing signal) that indicates or corresponds to a deterioration degree (or a degradation degree) of the sensor pixel TPX.

Various power voltages may be provided to the display panel 100. For example, power voltages may be provided to the display panel 100 from a power supply such as a power management integrated circuit (PMIC). The power voltages may be driving voltages necessary for an operation of the pixel PX, and for example, the power voltages may include a first power voltage VDD, a second power voltage VSS, a reference power voltage VREF, and an initialization power voltage VINT. The power voltages are described later with reference to FIG. 2 in relation to the operation of the pixel PX.

The scan driver 200 may supply a scan signal to the scan line SL based on a scan driving signal SCS. The scan driving signal SCS may include a start signal, clock signals, and the like, and may be provided from the timing controller 500 to the scan driver 200. For example, the scan driver 200 may be implemented as a shift register that generates and outputs the scan signal by sequentially shifting the pulse shape of start signal using the clock signals.

The scan driver 200 may be formed together with the pixels PX on the display panel 100. For example, the scan driver 200 may be formed in a gate driver in panel (GIP) method in the non-display area at one or both edges of the display panel 100. However, embodiments of the disclosure are not limited thereto, and the scan driver 200 may be formed in the display area of the display panel 100. However, the scan driver 200 of embodiments is not limited thereto, and for example, the scan driver 200 may be implemented as an integrated circuit and mounted on a circuit film.

The emission driver 300 may supply an emission control signal to the emission control line ECL based on an emission driving signal ECS. The emission driving signal ECS may include an emission start signal, emission clock signals, and the like, and may be provided from the timing controller 500 to the emission driver 300. For example, the emission driver 300 may be implemented as a shift register that generates and outputs the emission control signal by sequentially shifting the pulse shape of emission start signal using the emission clock signals.

Similarly to the scan driver 200, the emission driver 300 may be formed together with the pixels PX on the display panel 100 or implemented as an integrated circuit.

The data driver 400 may generate the data signal (or the data voltage) based on image data DATA1 and a data driving signal DCS and provide the data signal to the display panel 100 (or the pixel PX) through the data line DL. The image data DATA1 and the data driving signal DCS may be provided from the timing controller 500. The data driving signal DCS may be a signal that controls an operation of the data driver 400 and may include a horizontal start signal, a data clock signal, and the like. For example, the data driver 400 may include a shift register that generates a sampling signal by shifting the horizontal start signal in synchronization with the data clock signal, a latch that latches the image data DATA1 in response to the sampling signal, a digital-to-analog converter (or decoder) that converts the latched image data (for example, digital data) into an analog data signal, and a buffer (or an amplifier) that outputs the data signal to the data lines DL.

In an embodiment, the data driver 400 may provide the sensor data signal to the sensor data line TDL. For example, the data driver 400 may provide a sensor data signal having a reference voltage level (for example, a voltage level corresponding to a maximum grayscale) to the sensor data line TDL during a driving period (or in a first mode), and may provide a sensor data signal having a specific voltage level (for example, a voltage level corresponding to an arbitrary grayscale within a grayscale range of a minimum grayscale to a maximum grayscale) to the sensor data line TDL in a sensing period (or in a second mode). For example, the image data DATA1 or the data driving signal DCS may include a grayscale value (and timing information for the driving/sensing period) for the sensor pixel TPX, and the data driver 400 may generate the sensor data signal based on the image data DATA1 or the data driving signal DCS. During the driving period, the sensor pixel TPX may be deteriorated in response to the sensor data signal of the reference voltage level. In the sensing period, the deterioration degree of the sensor pixel TPX for a specific grayscale (or for each grayscale), for example, sensing information SI, may be obtained.

The timing controller 500 may receive the input image data IDATA and a control signal CS from an external device (for example, a host processor or a main processor). The input image data IDATA may include at least one image frame. The control signal CS may include a synchronization signal, a clock signal, and the like.

The timing controller 500 may generate the scan driving signal SCS for controlling an operation timing of the scan driver 200, the emission driving signal ECS for controlling an operation timing of the emission driver 300, and the data driving signal DCS for controlling an operation timing of the data driver 400 based on the control signal CS. The timing controller 500 may provide the scan driving signal SCS to the scan driver 200, provide the emission driving signal ECS to the emission driver 300, and provide the data driving signal DCS to the data driver 400.

In addition, the timing controller 500 may generate the image data DATA1 by converting the input image data IDATA. For example, the timing controller 500 may convert the input image data IDATA into the image data DATA1 having a format corresponding to an arrangement of the pixel PX in the display panel 100 (for example, format conversion operation). As another example, the timing controller 500 may generate the image data DATA1 by compensating for the input image data IDATA using a deterioration compensation technique (or a degradation compensation technique) or the like for compensating for the deterioration (or the degradation) of the pixel PX (for example, a deterioration compensation operation). In addition, the timing controller 500 may generate the image data DATA1 by compensating for the input image data IDATA using various compensation techniques in addition to the deterioration compensation technique.

In an embodiment, the timing controller 500 may generate the image data DATA1 by compensating for the input image data IDATA based on sensing data SDATA. The sensing data SDATA may be provided from the sensing driver 600. For example, the timing controller 500 may calculate a stress (or an accumulated stress) of the pixel PX by accumulating the input image data IDATA, predict a deterioration characteristic (for example, a deterioration characteristic according to the stress) of the pixel PX based on the sensing data SDATA (or the sensing information SI for the sensor pixel TPX), and compensate for the input image data IDATA based on the deterioration characteristic of the pixel PX. For example, in case that the sensor data signal corresponding to the maximum grayscale is continuously applied to the sensor pixel TPX, the sensor pixel TPX may be deteriorated faster than the pixel PX, and the deterioration characteristics (for example, a deterioration degree for each stress or a compensation value based thereon) applicable to the pixel PX (or all pixels) may be obtained from the sensing information SI of the sensor pixel TPX. For example, the sensing information SI may be representatively obtained from the sensor pixel TPX instead of each pixel PX, and data compensation may be performed based on the stress of the pixel PX and the sensing information SI.

The sensing driver 600 may obtain the sensing information SI for the sensor pixel TPX. For example, the sensing driver 600 may directly measure a current flowing through the sensor pixel TPX and obtain the current as the sensing information SI. In addition, the sensing driver 600 may generate the sensing data SDATA based on the sensing information SI. For example, the sensing driver 600 may generate the sensing data SDATA by converting analog sensing information SI into a digital value. The sensing driver 600 may be implemented as an integrated circuit, but embodiments of the disclosure are not limited thereto.

FIG. 2 is a schematic circuit diagram illustrating an embodiment of the pixel included in the display device of FIG. 1. Since the pixels PX1 to PX4 included in the display device 10 of FIG. 1 may be substantially equal or similar to each other, the pixels PX are described below including the pixels PX1 to PX4.

Referring to FIGS. 1 and 2, the pixel PX may be connected to a scan line SL, an emission control line ECL, and a data line DL. The scan line SL may include a first scan line SL1, a second scan line SL2, and a third scan line SL3. Driving signals DRS may be applied to the scan line SL, the emission control line ECL, and the data line DL. A first scan signal GW may be applied to the first scan line SL1, a second scan signal GB may be applied to the second scan line SL2, and a third scan signal GI may be applied to the third scan line SL3. An emission control signal EM may be applied to the emission control line ECL, and a data signal Vdata (or a data voltage) may be applied to the data line DL.

In addition, the pixel PX may be further connected to a first power line PL1, a second power line PL2, a reference power line RFL, and an initialization power line INL. A first power voltage VDD may be applied to the first power line PL1, a second power voltage VSS may be applied to the second power line PL2, a reference power voltage VREF may be applied to the reference power line RFL, and an initialization power voltage VINT may be applied to the initialization power line INL.

The pixel PX may include a pixel circuit PXC and a light emitting element LD.

The pixel circuit PXC may include a first transistor T1 (or a driving transistor), a second transistor T2, and a first capacitor Cst (or a storage capacitor). In an embodiment, the pixel circuit PXC may further include a third transistor T3, a fourth transistor T4, a fifth transistor T5, and a second capacitor Chold (or a hold capacitor).

The first transistor T1 may be connected between the first power line PL1 and a second node N2. For example, a first electrode of the first transistor T1 may be connected to the first power line PL1 via the fifth transistor T5, and a second electrode of the first transistor T1 may be connected to the second node N2. A gate electrode of the first transistor T1 may be connected to a first node N1. The first transistor T1 may supply a driving current to the light emitting element LD. For example, the first transistor T1 may supply a driving current corresponding to a voltage of the first node N1 to the light emitting element LD.

The second transistor T2 may be connected between the data line DL and the first node N1. A gate electrode of the second transistor T2 may be connected to the first scan line SL1. The second transistor T2 may be turned on in response to the first scan signal GW of the first scan line SL1. In case that the second transistor T2 is turned on, the data signal Vdata of the data line DL may be transferred to the first node N1.

The third transistor T3 may be connected between the reference power line RFL and the first node N1. A gate electrode of the third transistor T3 may be connected to the second scan line SL2. The third transistor T3 may be turned on in response to the second scan signal GB of the second scan line SL2. In case that the third transistor T3 is turned on, the reference power voltage VREF may be transferred to the first node N1.

The fourth transistor T4 may be connected between the second node N2 and the initialization power line INL. A gate electrode of the fourth transistor T4 may be connected to the third scan line SL3. The fourth transistor T4 may be turned on in response to the third scan signal GI of the third scan line SL3. In case that the fourth transistor T4 is turned on, the initialization power voltage VINT may be transferred to the second node N2.

The fifth transistor T5 may be connected between the first power line PL1 and the first transistor T1. A gate electrode of the fifth transistor T5 may be connected to the emission control line ECL. The fifth transistor T5 may be turned on in response to the emission control signal EM of the emission control line ECL. In case that the fifth transistor T5 is turned on, a current path through which the driving current may flow from the first power line PL1 to the second power line PL2 via the pixel circuit PXC and the light emitting element LD may be formed.

The first capacitor Cst may be formed or connected between the first node N1 and the second node N2. A voltage corresponding to the data voltage Vdata may be stored in the first capacitor Cst.

The second capacitor Chold may be formed or connected between the first power line PL1 and the second node N2. The second capacitor Chold may stabilize a voltage of the second node N2.

The light emitting element LD may be connected between the second node N2 and the second power line PL2. For example, the light emitting element LD may be connected in a forward direction between the second node N2 and the second power line PL2. In case that the driving current is supplied from the first transistor T1, the light emitting element LD may emit light with a luminance corresponding to the driving current.

In an embodiment, the light emitting element LD may include an organic light emitting diode. In another embodiment, the light emitting element LD may include at least one inorganic light emitting diode. A type, a size, and/or the number of light emitting elements LD may be changed according to an embodiment.

The first to fifth transistors T1 to T5 may be N-type transistors, but embodiments of the disclosure are not limited thereto. For example, at least one of the first to fifth transistors T1 to T5 may be changed to a P-type transistor. A voltage level of the driving signals DRS for controlling an operation of the transistor may be set according to the type of each transistor.

In an embodiment, at least one of the first to fifth transistors T1 to T5 may include an oxide semiconductor. For example, at least one transistor including the first transistor T1 may be an oxide semiconductor transistor including an oxide semiconductor.

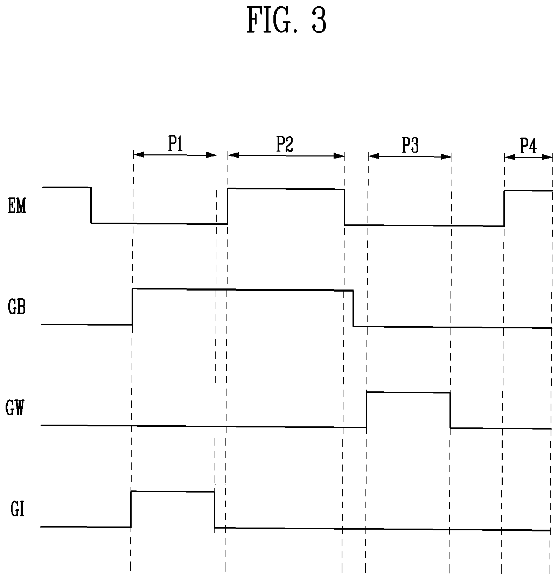

FIG. 3 is a schematic waveform diagram illustrating an embodiment of an operation of the pixel of FIG. 2.

Referring to FIGS. 2 and 3, in a first period P1, the emission control signal EM may have a gate-off voltage level. The fifth transistor T5 may be turned off, the current path may be blocked, and the light emitting element LD may not emit light. In the first period P1, the first scan signal GW may have a gate-off voltage level.

In addition, in the first period P1, the second scan signal GB may have a gate-on voltage level. The third transistor T3 may be turned on and the first node N1 may be initialized by the reference power voltage VREF. In the first period P1, the third scan signal GI may have a gate-on voltage level. The fourth transistor T4 may be turned on, and the second node N2 may be initialized by the initialization power voltage VINT. For example, in the first period P1, the pixel PX may be initialized.

In a second period P2, the emission control signal EM may have a gate-on voltage level. The fifth transistor T5 may be turned on.

In addition, in the second period P2, the second scan signal GB may have a gate-on voltage level. The voltage of the second node N2 may be changed by the driving current flowing through the first transistor T1, and for example, the voltage of the second node N2 may be changed to a value obtained by subtracting a threshold voltage of the first transistor T1 from the voltage of the first node N1 (for example, the reference power voltage VREF). Therefore, a voltage corresponding to the threshold voltage of the first transistor T1 may be stored in the first capacitor Cst. For example, in the second period P2, the threshold voltage of the first transistor T1 may be compensated.

In order to maintain the light emitting element LD in a non-emission state during the second period P2, the reference power voltage VREF may be set to a voltage level capable of maintaining the light emitting element LD in the non-emission state.

In the second period P2, each of the first scan signal GW and the third scan signal GI may have a gate-off voltage level.

In a third period P3, the first scan signal GW may have a gate-on voltage level. The second transistor T2 may be turned on, and the data signal Vdata may be transferred to the first node N1. In the third period P3, each of the emission control signal EM, the second scan signal GB, and the third scan signal GI may have a gate-off voltage level. The third transistor T3, the fourth transistor T4, and the fifth transistor T5 may be turned off.

Since the voltage of the second node N2 has a voltage obtained by subtracting the threshold voltage of the first transistor T1 from the reference power voltage VREF, "data signal Vdata - reference power voltage VREF + threshold voltage", for example, a data signal in which the threshold voltage is compensated may be stored in the first capacitor Cst in the third period P3. For example, in the third period P3, the data signal Vdata may be written to the pixel PX.

In a fourth period P4, the emission control signal EM may have a gate-on voltage level. The fifth transistor T5 may be turned on. A current path may be formed between the first power line PL1 and the second node N2, and the first transistor T1 may supply a driving current corresponding to the voltage stored in the first capacitor Cst to the light emitting element LD, and the light emitting element LD may emit light with a luminance corresponding to the driving current.

In the fourth period P4, each of the first scan signal GW, the second scan signal GB, and the third scan signal GI may have a gate-off voltage level.

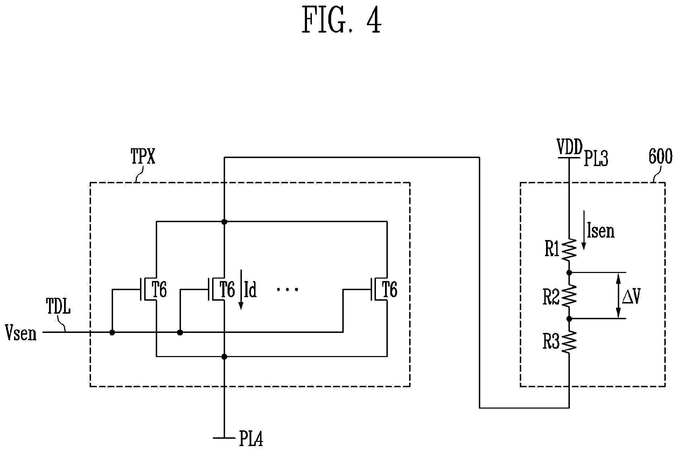

FIG. 4 is a schematic circuit diagram illustrating an embodiment of the sensor pixel and the sensing driver included in the display device of FIG. 1. In FIG. 4, the sensing driver 600 is shown based on a current sensing function.

First, referring to FIGS. 1 and 4, the sensor pixel TPX may include a sixth transistor T6 (a sensor transistor, or a test transistor). The sixth transistor T6 may be connected between a third power line PL3 and a fourth power line PL4, and a gate electrode of the sixth transistor T6 may be connected to the sensor data line TDL. The sensor data signal (or a test data signal) may be applied to the sensor data line TDL. The first power voltage VDD may be applied to the third power line PL3. The third power line PL3 may be substantially the same as the first power line PL1 of FIG. 2. A voltage lower than the first power voltage VDD may be applied to the fourth power line PL4. For example, the initialization power voltage VINT of FIG. 2 may be applied to the fourth power line PL4, but embodiments of the disclosure are not limited thereto. In a range in which the sixth transistor T6 may be driven under substantially the same driving condition as the first transistor T1 in the pixel PX of FIG. 2, a voltage applied to the fourth power line PL4 (and/or the third power line PL3) may be variously set or changed.

In an embodiment, the sensor pixel TPX may not include another configuration (for example, another transistor or light emitting element) except for the sixth transistor T6.

In embodiments, the sensor pixel TPX may include multiple sixth transistors T6 connected in parallel between the third power line PL3 and the fourth power line PL4. For example, the sensor pixel TPX may include at least three sixth transistors T6. For example, the sensor pixel TPX may include 24 sixth transistors T6. Gate electrodes of the sixth transistors T6 may be commonly connected to the sensor data line TDL. A magnitude of a driving current Id flowing through one sixth transistor T6 may not be large enough for direct current sensing, and an error may occur in sensing only the driving current Id flowing through one sixth transistor T6. Therefore, since the sensor pixel TPX includes multiple sixth transistors T6 parallel to each other, the driving current Id (or a sensor current Isen corresponding thereto) of the sixth transistor T6 may be directly sensed, and a more accurate value (or an average value) of the driving current Id may be measured.

Referring to FIGS. 2 and 4, in an embodiment, each sixth transistor T6 of the sensor pixel TPX may have the same structure as the first transistor T1 of the pixel PX of FIG. 2. For example, each of the sixth transistor T6 of the sensor pixel TPX and the first transistor T1 of the pixel PX may have the same material (or the same semiconductor material), the same size, the same channel capacitance, the same shape (or the same planar shape or cross-sectional shape), and the like, and may be formed simultaneously through the same process. Accordingly, each of the sixth transistor T6 of the sensor pixel TPX and the first transistor T1 of the pixel PX may have substantially a same characteristic, for example, the same deterioration characteristic. For example, each of the sixth transistor T6 of the sensor pixel TPX and the first transistor T1 of the pixel PX may be deteriorated in substantially the same manner.

The sensing driver 600 may sense or measure the sensor current Isen flowing through the sensor pixel TPX. The sensor current Isen may correspond to or be proportional to the driving current Id flowing through each sixth transistor T6 in the sensor pixel TPX. The sensing driver 600 may be connected between the third power line PL3 and the sensor pixel TPX to sense the sensor current Isen. However, embodiments of the disclosure are not limited thereto, and for example, the sensing driver 600 may be connected between the sensor pixel TPX and the fourth power line PL4 to sense the sensor current Isen. For example, a disposition position of the sensor pixel TPX may be variously changed within a range in which the sensor current Isen flowing through the sensor pixel TPX may be sensed.

In an embodiment, the sensing driver 600 may include a second resistor R2 (or a senor resistor) connected to the sensor pixel TPX in series between the third power line PL3 and the fourth power line PL4, and may measure a voltage ΔV between both ends of the second resistor R2. Since a size of the second resistor R2 is preset, the sensor current Isen may be calculated based on the second resistor R2 and the voltage ΔV. For example, an end of the second resistor R2 may be connected to the third power line PL3 through the first resistor R1, and another end of the second resistor R2 may be connected to the fourth power line PL4 through a third resistor R3. A first resistor R1 may mean a resistance component between the second resistor R2 and the third power line PL3, and the third resistor R3 may mean a resistance component between the second resistor R2 and the sensor pixel TPX.

As described above, the sensor pixel TPX may include the sixth transistors T6 connected in parallel with each other, and each of the sixth transistors T6 may have the same structure as the first transistor T1 in the pixel PX of FIG. 2. The sensing driver 600 may directly sense the sensor current Isen flowing through the sensor pixel TPX.

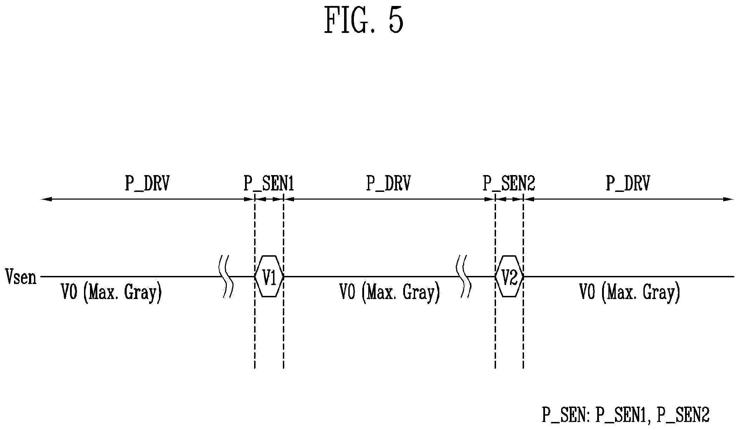

FIG. 5 is a schematic waveform diagram illustrating an embodiment of an operation of the sensor pixel and the sensing driver of FIG. 4.

Referring to FIGS. 4 and 5, in a driving period P_DRV (a first period, or a first mode), a sensor data signal Vsen may have a reference voltage V0 (or a reference voltage level). For example, the reference voltage V0 may have a voltage level corresponding to a maximum grayscale (Max. Gray) within a grayscale range. For example, in case that the pixel PX of FIG. 2 expresses a grayscale range between a minimum grayscale of 0 and a maximum grayscale of 255, the reference voltage V0 may correspond to the maximum grayscale of 255 that causes the pixel PX to emit light with the highest luminance. In case that the reference voltage V0 is continuously applied to the sensor pixel TPX during the driving period P_DRV, the sixth transistor T6 (or the sensor pixel TPX) may be deteriorated. For example, compared to the first transistor T1 (refer to FIG. 2) of the pixel PX (refer to FIG. 2) that emits light in response to a variable grayscale, the sixth transistor T6 operating in response to the maximum grayscale may be deteriorated fast.

In a sensing period P_SEN (a second period, or a second mode), the sensor data signal Vsen may have a voltage (or a voltage level) corresponding to a specific grayscale. For example, in a first sensing period P_SEN1, the sensor data signal Vsen may have a first voltage V1 corresponding to a first grayscale. The sensing driver 600 may obtain a value of the sensor current Isen flowing through the sensor pixel TPX in correspondence with the first grayscale. In such a method, based on the first grayscale, a characteristic change of the sixth transistor T6 according to deterioration (a stress, or a driving time) may be derived, and a compensation value (or compensation data) for the first grayscale may be calculated for each deterioration degree (stress value, or driving time).

For example, in a second sensing period P_SEN2, the sensor data signal Vsen may have a second voltage V2 corresponding to a second grayscale. The sensing driver 600 may obtain the value of the sensor current Isen flowing through the sensor pixel TPX in correspondence with the second grayscale. In such a method, based on the second grayscale, a characteristic change of the sixth transistor T6 according to deterioration may be derived, and a compensation value (or compensation data) for the second grayscale may be calculated for each deterioration degree (stress value, or driving time).

In the above-described method, a compensation value for each deterioration information for each grayscale within the grayscale range may be calculated.

The sensing period P_SEN may be allocated periodically and/or in case that an event occurs. For example, while the display device 10 is powered on and driven, the sensing period P_SEN may be periodically allocated. As another example, the sensing period P_SEN may be allocated at a time point in case that the display device 10 is powered on or powered off. A remaining period except for the sensing period P_SEN of the entire driving period of the display device 10 may be the driving period P_DRV. The driving period P_DRV and the sensing period P_SEN may be independent of a period in which an image is displayed on the display device 10.

In FIG. 5, a sensing operation for the first grayscale may be performed in the first sensing period P_SEN1 and a sensing operation for the second grayscale may be performed in the second sensing period P_SEN2, but embodiments of the disclosure are not limited thereto. For example, a sensing operation for multiple grayscales may be sequentially performed within one sensing period P_SEN.

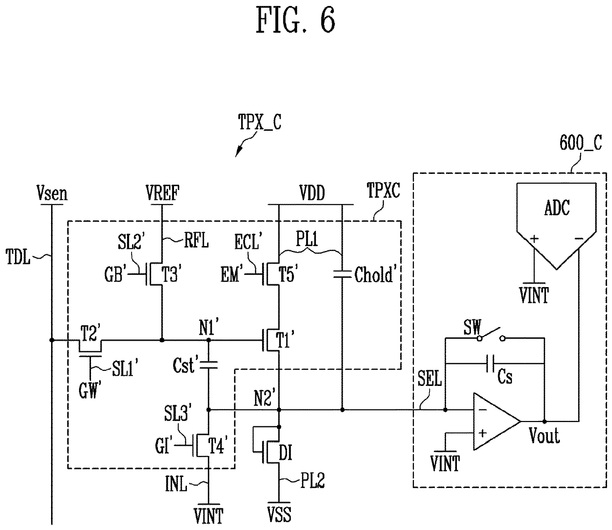

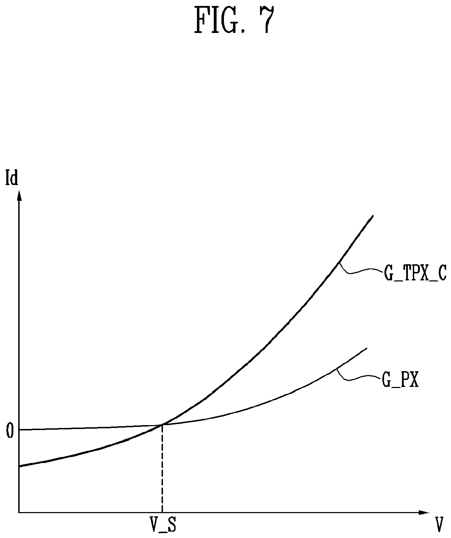

FIG. 6 is a schematic circuit diagram illustrating a comparative example of the sensor pixel and the sensing driver. FIG. 7 is a schematic diagram illustrating currents measured in the sensor pixel of FIG. 6 and the pixel of FIG. 2.

First, referring to FIGS. 2 and 6, except for a non-light emitting diode DI, the sensor pixel TPX_C of FIG. 6 may be substantially the same as or similar to the pixel PX of FIG. 2. In addition, similar reference numerals are assigned to the same or similar configurations in FIGS. 2 and 6. Therefore, redundant description is omitted.

The sensor pixel TPX_C may include a sensor pixel circuit TPXC and the non-light emitting diode DI.

The non-light emitting diode DI may be connected between a second node N2' (or the sensor pixel circuit TPXC) and the second power line PL2. The non-light emitting diode DI may have a structure in which a transistor is diode-connected in a forward direction. The non-light emitting diode DI may be a component that simulates the light emitting element LD of FIG. 2 (for example, a simulated light emitting element) and may not emit light differently from the light emitting element LD.

The sensing driver 600_C may be connected to the sensor pixel TPX_C (or the second node N2') through a sensing line SEL, and may sense a current flowing through the sensor pixel circuit TPXC during the sensing period.

For example, the sensing driver 600_C may include an amplifier, a switch SW, a third capacitor Cs, and an analog-to-digital converter ADC. A connection relationship between the amplifier, the switch SW, the third capacitor Cs, and the analog-to-digital converter ADC is as shown in FIG. 6, and a description thereof is omitted. The amplifier, the switch SW, and the third capacitor Cs shown in FIG. 6 may configure one integrator, and may integrate the current flowing through the sensor pixel circuit TPXC during the sensing period. Since a magnitude of a current flowing through one sensor pixel TPX_C is not sufficiently large, the sensing driver 600_C may sense the current through an integrator.

For reference, the initialization power voltage VINT may be applied to a first input terminal of the amplifier, and in the sensing period, the initialization power voltage VINT may be applied to the second node N2' through a second input terminal of the amplifier. An output terminal Vout of the amplifier may be connected to the second input terminal of the amplifier through the switch SW.

The non-light emitting diode DI may be deteriorated by use, and a characteristic (for example, a threshold voltage) of the non-light emitting diode DI may be changed.

By a combination of the non-light emitting diode DI and a structure for applying the initialization power voltage VINT to the sensor pixel TPX_C (or the second node N2'), the current sensed in the sensor pixel TPX_C may be different from a current actually flowing through the pixel.

Referring to FIG. 7, a first curve G_TPX_C represents a driving current according to a voltage (for example, the sensor data signal Vsen) measured in the sensor pixel TPX_C of FIG. 6, and a second curve G_PX represents a driving current according to the voltage (for example, the data signal Vdata) measured in the pixel PX of FIG. 2. Here, the sensor pixel TPX_C and the pixel PX may be in an equally deteriorated state.

The first curve G_TPX_C may appear differently from the second curve G_PX. The driving current Id of the sensor pixel TPX_C may appear less than 0 in a period where the voltage is equal to or less than a specific voltage V_S. For example, a reverse current may be measured in the sensor pixel TPX_C.

Due to a difference between the first curve G_TPX_C and the second curve G_PX, data compensation for the pixel PX of FIG. 2 using the first curve G_TPX_C (or a compensation value calculated based thereon) may not be performed accurately.

Therefore, as shown in FIG. 4, the sensor pixel TPX according to embodiments of the disclosure may not include the non-light emitting diode DI of FIG. 6. In addition, the sensor pixel TPX may include only the sixth transistor T6 and may not include another transistor or capacitor. Only a characteristic of the sixth transistor T6 (for example, the driving transistor) may be accurately sensed. Furthermore, as shown in FIG. 4, the sensing driver 600 may directly sense the current flowing through the sensor pixel TPX instead of integrating the current. To this end, the sensor pixel TPX may include the sixth transistors T6 connected in parallel.

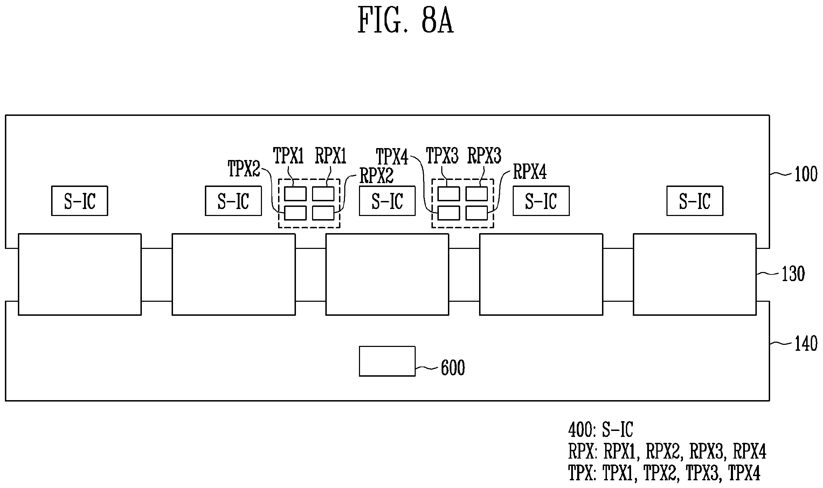

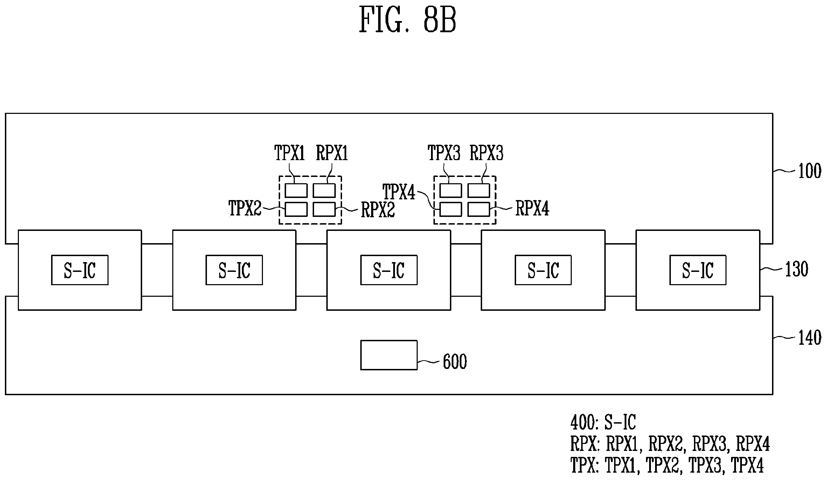

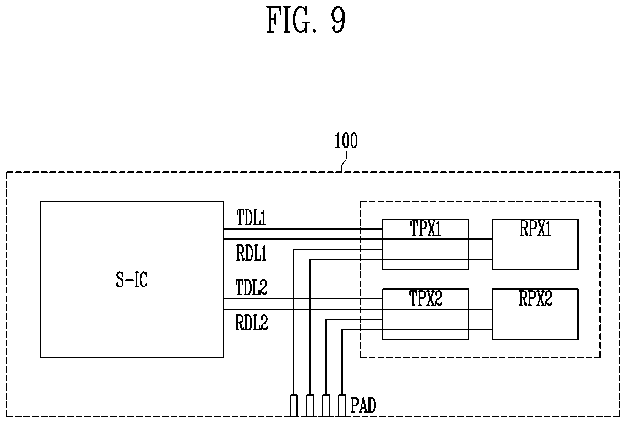

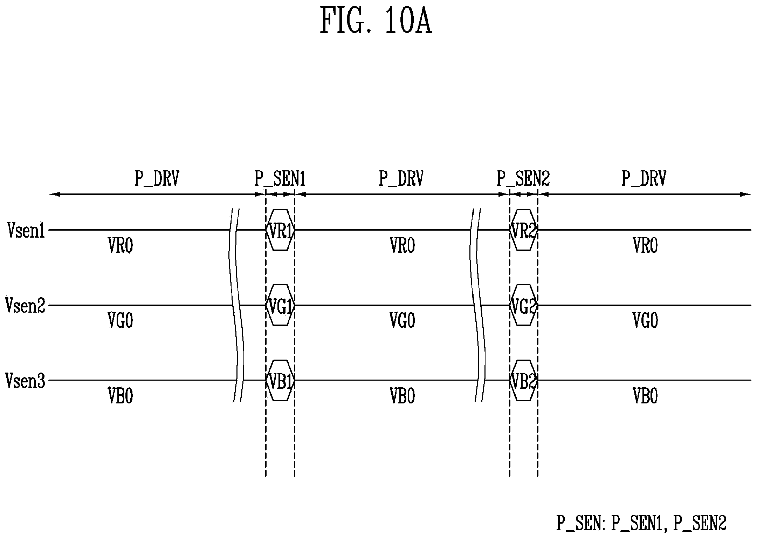

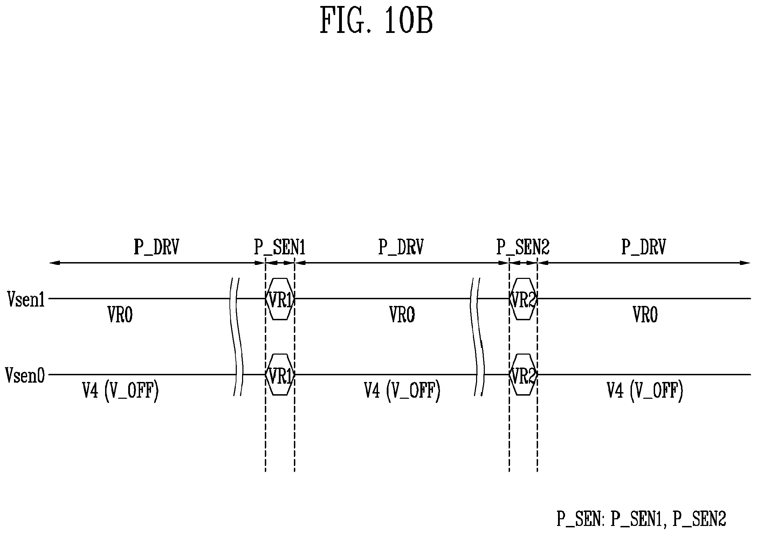

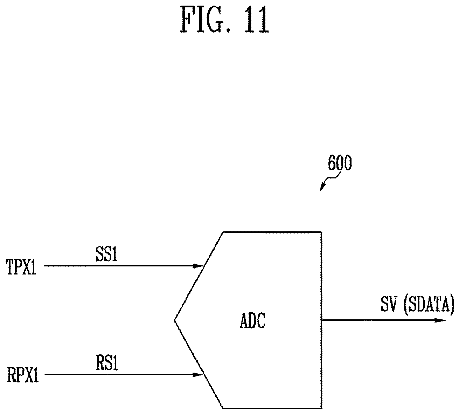

FIGS. 8A and 8B are schematic plan views illustrating an embodiment of the display device of FIG. 1. FIGS. 8A and 8B show the display device 10 of FIG. 1 based on the sensor pixel TPX. FIG. 9 is an enlarged schematic plan view of a portion of a display panel of FIG. 8A. FIG. 10A is a schematic waveform diagram illustrating an embodiment of signals provided to sensor pixels of FIGS. 8A and 8B. FIG. 10B is a schematic waveform diagram illustrating an embodiment of signals provided to a first sensor pixel and a first reference pixel of FIGS. 8A and 8B. FIG. 11 is a schematic diagram illustrating an embodiment of the sensing driver of FIGS. 8A and 8B.

First, referring to FIGS. 1, 8A, and 8B, the sensing driver 600 may be mounted on a printed circuit board 140 and connected to the display panel 100 through a flexible film 130 (or a connection film).

The data driver 400 may include multiple data integrated circuits S-IC. As shown in FIG. 8A, the data integrated circuits S-IC may be mounted on the display panel 100. However, embodiments of the disclosure are not limited thereto, and for example, as shown in FIG. 8B, each data integrated circuit S-IC may be mounted on the flexible film 130.

In an embodiment, the sensor pixel TPX may be disposed between two data integrated circuits S-IC adjacent to each other. As shown in FIG. 8A, on a horizontal line where the data integrated circuits S-IC are arranged (or in a direction in which the data integrated circuits S-IC are arranged), the sensor pixels TPX may be disposed between two data integrated circuits S-IC adjacent to each other. As shown in FIG. 8B, even though the sensor pixel TPX is positioned on a horizontal line different from that of the data integrated circuits S-IC, the sensor pixel TPX may be disposed between two data integrated circuits S-IC adjacent to each other based on a vertical direction. The sensor pixel TPX (and signal lines connected thereto) may be spaced apart from another configuration (for example, the data line DL of FIG. 1 or the like), and interference of the other configuration on the sensor pixel TPX may be excluded, and the sensing information SI for the sensor pixel TPX may be obtained more accurately.

In an embodiment, the display panel 100 (or the sensor pixel TPX) may include multiple sensor pixels TPX1 to TPX4. For example, the display panel 100 may include a first sensor pixel TPX1, a second sensor pixel TPX2, a third sensor pixel TPX3, and a fourth sensor pixel TPX4. The first sensor pixel TPX1 may correspond to the first pixel PX1 of FIG. 1, and may be used to predict a deterioration characteristic of the first pixel PX1 (for example, the red pixel). The second sensor pixel TPX2 may correspond to the second pixel PX2 of FIG. 1, and may be used to predict a deterioration characteristic of the second pixel PX2 (for example, the green pixel). The third sensor pixel TPX3 may correspond to the third pixel PX3 of FIG. 1, and may be used to predict a deterioration characteristic of the third pixel PX3 (for example, the blue pixel). The fourth sensor pixel TPX4 may correspond to the fourth pixel PX4 of FIG. 1, and may be used to predict a deterioration characteristic of the fourth pixel PX4 (for example, the green pixel, the white pixel, or the like). Each of the first sensor pixel TPX1, the second sensor pixel TPX2, the third sensor pixel TPX3, and the fourth sensor pixel TPX4 may be substantially the same as the sensor pixel TPX of FIG. 4.

Referring to FIGS. 4, 9, and 10A, the first sensor pixel TPX1 may be connected to the data integrated circuit S-IC through a first sensor data line TDL1. The first sensor pixel TPX1 may be connected to the sensing driver 600 through a pad PAD of the display panel 100 and the flexible film 130.

The data integrated circuit S-IC may provide a first sensor data signal Vsen1 to the first sensor data line TDL1. As shown in FIGS. 10A and 10B, in the driving period P_DRV (the first period, or the first mode), the first sensor data signal Vsen1 may have a first reference voltage VR0 (or a first reference voltage level). For example, in case that the first pixel PX1 (refer to FIG. 1) is a red pixel, the first reference voltage VR0 may be equal to a maximum data voltage applied to the red pixel. In the sensing period P_SEN (the second period, or the second mode), the first sensor data signal Vsen1 may have voltages VR1 and VR2 corresponding to specific grayscales. In the sensing period P_SEN, the sensing driver 600 may obtain a value of a sensor current flowing through the first sensor pixel TPX1 corresponding to the specific grayscales. The deterioration characteristic of the first pixel PX1 (refer to FIG. 1) may be predicted based on the value.

Similarly to the first sensor pixel TPX1, the second sensor pixel TPX2 may be connected to the data integrated circuit S-IC through a second sensor data line TDL2. The second sensor pixel TPX2 may also be connected to the sensing driver 600 through the pad PAD of the display panel 100 and the flexible film 130. The data integrated circuit S-IC may provide a second sensor data signal Vsen2 to the second sensor data line TDL2. As shown in FIG. 10A, in the driving period P_DRV, the second sensor data signal Vsen2 may have a second reference voltage VG0 (or a second reference voltage level). The second reference voltage VG0 may be different from the first reference voltage VR0. For example, in case that the second pixel PX2 (refer to FIG. 1) is a green pixel, the second reference voltage VG0 may be equal to the maximum data voltage applied to the green pixel. In the sensing period P_SEN, the second sensor data signal Vsen2 may have voltages VG1 and VG2 corresponding to specific grayscales. In the sensing period P_SEN, the sensing driver 600 may obtain a value of a sensor current flowing through the second sensor pixel TPX2 corresponding to the specific grayscales. The deterioration characteristic of the second pixel PX2 (refer to FIG. 1) may be predicted based on the value.

The data integrated circuit S-IC may provide a third sensor data signal Vsen3 to the third sensor pixel TPX3. As shown in FIG. 10A, in the driving period P_DRV, the third sensor data signal Vsen3 may have a third reference voltage VB0 (or a third reference voltage level). The third reference voltage VB0 may be different from the first and second reference voltages VR0 and VG0. For example, in case that the third pixel PX3 (refer to FIG. 1) is a blue pixel, the third reference voltage VB0 may be equal to a maximum data voltage applied to the blue pixel. In the sensing period P_SEN, the third sensor data signal Vsen3 may have voltages VB1 and VB2 corresponding to specific grayscales. In the sensing period P_SEN, the sensing driver 600 may obtain a value of a sensor current flowing through the third sensor pixel TPX3 corresponding to the specific grayscales. A deterioration characteristic of the third pixel PX3 (refer to FIG. 1) may be predicted based on the value.

In an embodiment, the display panel 100 may further include a reference pixel RPX. For example, the display panel 100 (or the reference pixel RPX) may include a first reference pixel RPX1 (or a fifth sensor pixel), a second reference pixel RPX2 (or a sixth sensor pixel), a third reference pixel RPX3 (or a seventh sensor pixel), and a fourth reference pixel RPX4 (or an eighth sensor pixel). The first reference pixel RPX1 may form a pair with the first sensor pixel TPX1. Similarly, the second reference pixel RPX2 may form a pair with the second sensor pixel TPX2, the third reference pixel RPX3 may form a pair with the third sensor pixel TPX3, and the fourth reference pixel RPX4 may form a pair with the fourth sensor pixel TPX4. As will be described later, by comparing a sensing current of the sensor pixel TPX which is deteriorated with a sensing current of the reference pixel RPX (for example, the reference pixel RPX forming a pair with the sensor pixel TPX) which is not deteriorated, the deterioration degree of the sensor pixel TPX may be measured more accurately. Each of the first reference pixel RPX1, the second reference pixel RPX2, the third reference pixel RPX3, and the fourth reference pixel RPX4 may be substantially the same as the sensor pixel TPX of FIG. 4.

Referring to FIGS. 4, 9, and 10B, the first reference pixel RPX1 may be connected to the data integrated circuit S-IC through a first reference data line RDL1 (or a fifth sensor data line). The first reference pixel RPX1 may be connected to the sensing driver 600 through the pad PAD of the display panel 100 and the flexible film 130. The data integrated circuit S-IC may provide a reference data signal Vsen0 (or a sensor data signal) to the first reference data line RDL1. As shown in FIG. 10B, in the driving period P_DRV, the reference data signal Vsen0 may have a fourth voltage V4. The fourth voltage V4 may be different from the first reference voltage VR0. For example, in the driving period P_DRV, the reference data signal Vsen0 (or the fourth voltage V4) may have a turn-off voltage V_OFF (or a gate-off voltage). During the driving period P_DRV, a current may not flow through the first reference pixel RPX1 and the first reference pixel RPX1 may not be substantially deteriorated. In the sensing period P_SEN, the reference data signal Vsen0 may have voltages VR1 and VR2 corresponding to specific grayscales. For example, in the sensing period P_SEN, the voltages VR1 and VR2 of the reference data signal Vsen0 provided to the first reference pixel RPX1 may be the same as the voltages VR1 and VR2 of the first sensor data signal Vsen1 provided to the first sensor pixel TPX1. For example, the same data signal may be provided to the first reference pixel RPX1 and the first sensor pixel TPX1 in the sensing period P_SEN.

Referring to FIGS. 9 and 11, the sensing driver 600 may include an analog-to-digital converter ADC. The analog-to-digital converter ADC may output a sensing value SV based on sensing signals of the sensor pixel and the reference pixel forming a pair (or a pair of sensor pixels). For example, a first sensing signal SS1 (for example, a value of a current flowing through the first sensor pixel TPX1) may be provided to a first input terminal of the analog-to-digital converter ADC from the first sensor pixel TPX1, and a first reference sensing signal RS1 (for example, a value of a current flowing through the first reference pixel RPX1) may be provided to a second input terminal of the analog-to-digital converter ADC from the first reference pixel RPX1. The analog-to-digital converter ADC may output the sensing value SV (or sensing data SDATA including the same) corresponding to a difference between the first sensing signal SS1 and the first reference sensing signal RS1. For example, the sensing driver 600 may obtain the sensing information SI (refer to FIG. 1) corresponding to the difference between the first sensing signal SS1 and the first reference sensing signal RS1.

Noise of the first sensing signal SS1 may be effectively removed based on the first reference sensing signal RS1, and a deterioration degree of the first sensor pixel TPX1 may be accurately measured based on the first reference pixel RPX1 which is not deteriorated.

Referring to FIGS. 4 and 9 again, similarly to the first reference pixel RPX1, the second reference pixel RPX2 may be connected to the data integrated circuit S-IC through a second reference data line RDL2. The second reference pixel RPX2 may be connected to the sensing driver 600 through the pad PAD of the display panel 100 and the flexible film 130. An operation of the second reference pixel RPX2 may be substantially the same as or similar to that of the first reference pixel RPX1 described with reference to FIG. 10B. In addition, an operation of the sensing driver 600 for the second reference pixel RPX2 and the second sensor pixel TPX2 may be substantially the same as or similar to the operation of the sensing driver 600 described with reference to FIG. 11. Therefore, redundant description is omitted.

As described above, the sensor pixel TPX may be provided in the display panel 100 for each type (or for each color) of the pixel PX, and thus a deterioration degree may be predicted for each type of the pixel PX. In addition, the reference pixel RPX (or another sensor pixel) forming a pair with the sensor pixel TPX may be further provided in the display panel 100, and a deterioration degree of the sensor pixel TPX may be measured more accurately based on the reference pixel RPX which is not deteriorated.

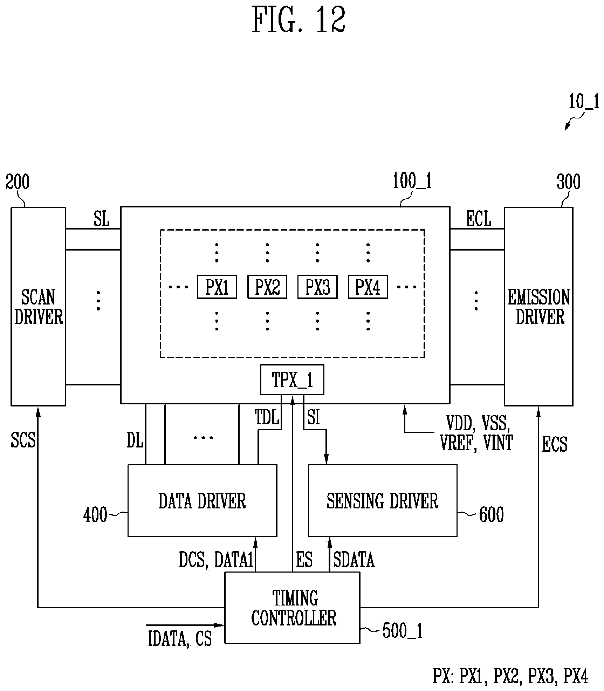

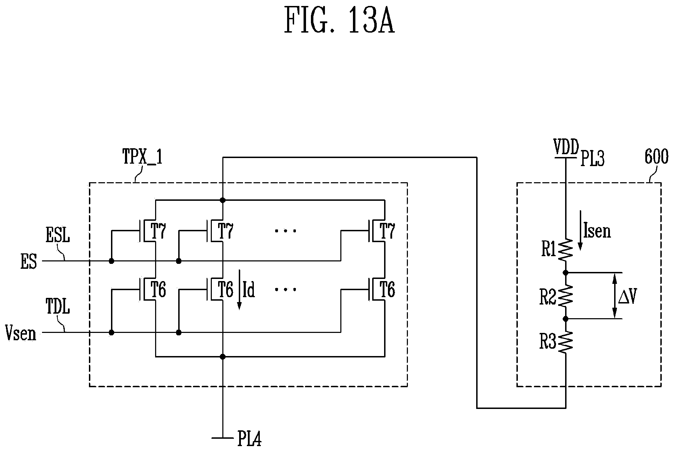

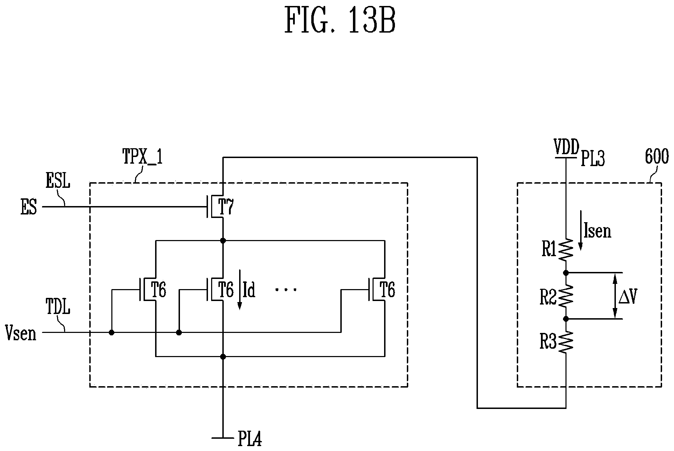

FIG. 12 is a schematic block diagram illustrating an embodiment of the display device of FIG. 1. FIGS. 13A and 13B are schematic circuit diagrams illustrating an embodiment of a sensor pixel and a sensing driver included in the display device of FIG. 12.

First, referring to FIGS. 1 and 12, except for a sensor pixel TPX_1, the display device 10_1 of FIG. 12 may be substantially the same as or similar to the display device 10 of FIG. 1, and thus redundant description is omitted.

A display panel 100_1 may include the sensor pixel TPX_1, and the sensor pixel TPX_1 may receive a sensor control signal ES from a timing controller 500_1.

Referring to FIGS. 4 and 13A, except for a seventh transistor T7 (or an auxiliary transistor), the sensor pixel TPX_1 of FIG. 13A may be substantially the same as or similar to the sensor pixel TPX of FIG. 4. Therefore, redundant description is omitted.

The sensor pixel TPX_1 may further include a protection circuit. For example, the protection circuit may include the seventh transistor T7. The seventh transistor T7 may be connected to each sixth transistor T6 in series between the third power line PL3 and the fourth power line PL4. A gate electrode of the seventh transistor T7 may be connected to the sensor control line ESL. A sensor control signal ES may be applied to the sensor control line ESL from the timing controller 500_1.

In case that a driving voltage (for example, a driving voltage for driving the pixel PX (refer to FIG. 2)) is applied to the sensor pixel TPX of FIG. 4, for example, the sensor pixel TPX configured of only the sixth transistor T6, there is a possibility that the sixth transistor T6 is damaged. Therefore, the sensor pixel TPX_1 of FIG. 13A may further include the seventh transistor T7, and in case that the sixth transistor T6 is turned off, the seventh transistor T7 may be turned off to prevent the sixth transistor T6 from being damaged.

In FIG. 13A, one sixth transistor T6 and one seventh transistor T7 are paired and arranged, but embodiments of the disclosure are not limited thereto. For example, as shown in FIG. 13B, the sensor pixel TPX_1 may include one seventh transistor T7 commonly connected to multiple sixth transistors T6.

As discussed, embodiments can provide a display device, comprising: a display panel including a pixel and a sensor pixel, the pixel including a light emitting element and a driving transistor arranged to control a current flowing through the light emitting element, the sensor pixel including sensor transistors; a data driver arranged to supply a data signal to the pixel through a data line and to provide a sensor data signal to the sensor pixel through a sensor data line; and a sensing driver arranged to obtain sensing information on a current flowing through the sensor pixel, wherein the sensor transistors are electrically connected in parallel to each other and are commonly electrically connected to the sensor data line, and the sensor transistors and the driving transistor include a substantially same characteristic.

The sensor transistors and the driving transistor may include a substantially same deterioration characteristic.

In some embodiments, the sensor transistors and the driving transistor include a same semiconductor material. The other materials may also be the same.

In some embodiments, the sensor transistors and the driving transistor include a same structure and shape.

In some embodiments, the sensor transistors and the driving transistor may be formed in a same process.

The sensor transistors and the driving transistor may have the same materials, the same size, the same channel capacitance, the same shape (or the same planar shape or cross-sectional shape), and the like, and may be formed simultaneously through the same process.

As discussed, embodiments can provide a display device, comprising: a display panel including a pixel and a sensor pixel, the pixel including a light emitting element and a driving transistor arranged to control a current flowing through the light emitting element, the sensor pixel including a sensor transistor; a data driver arranged to supply a data signal to the pixel through a data line and to provide a sensor data signal to the sensor pixel through a sensor data line; and a sensing driver arranged to obtain sensing information on a current flowing through the sensor pixel, wherein the sensor transistor and the driving transistor include a substantially same characteristic, and the sensor pixel does not include a light emitting element.

The sensor transistors and the driving transistor may include a substantially same deterioration characteristic.

In some embodiments, the sensor transistors and the driving transistor include a same semiconductor material. The other materials may also be the same.

In some embodiments, the sensor transistors and the driving transistor include a same structure and shape.

In some embodiments, the sensor transistors and the driving transistor may be formed in a same process.

The sensor transistors and the driving transistor may have the same materials, the same size, the same channel capacitance, the same shape (or the same planar shape or cross-sectional shape), and the like, and may be formed simultaneously through the same process

Although the disclosure has been described in detail in accordance with the above-described embodiments, it should be noted that the above-described embodiments are for the purpose of description and not of limitation. In addition, those skilled in the art will understand that various modifications are possible within the scope of the disclosure.

The scope of the disclosure is not limited to the details described in the detailed description of the specification. In addition, it is to be construed that all changes or modifications derived from the meaning and scope of the claims and equivalent concepts thereof are included in the scope of the disclosure.

## Claims

1. A display device, comprising:
a display panel including a pixel and a sensor pixel, the pixel including a light emitting element and a driving transistor arranged to control a current flowing through the light emitting element, the sensor pixel including sensor transistors;
a data driver arranged to supply a data signal to the pixel through a data line and to provide a sensor data signal to the sensor pixel through a sensor data line; and
a sensing driver arranged to obtain sensing information on a current flowing through the sensor pixel, wherein
the sensor transistors are electrically connected in parallel to each other and are commonly electrically connected to the sensor data line, and
the sensor transistors and the driving transistor include a substantially same characteristic.

2. The display device according to claim 1, wherein
the sensor transistors and the driving transistor include a same semiconductor material; and
the sensor transistors and the driving transistor include a same structure and shape.

3. The display device according to claim 1 or 2, wherein the sensor pixel does not include a light emitting element.

4. The display device according to any one of claims 1 to 3, wherein the sensor pixel includes at least three sensor transistors.

5. The display device according to any one of claims 1 to 4, wherein
the sensor pixel is electrically connected between a first power line and a second power line, and
the sensing driver arranged to measure a voltage between both ends of a resistor electrically connected to the sensor pixel in series between the first power line and the second power line.

6. The display device according to any one of claims 1 to 5, further comprising:
a timing controller arranged to predict a deterioration characteristic of the pixel based on the sensing information and compensates for image data based on the predicted deterioration characteristic of the pixel,
wherein the data driver is arranged to generate the data signal based on the compensated image data.

7. The display device according to any one of claims 1 to 6, wherein
the data driver includes a plurality of data integrated circuits mounted on the display panel, and
in a plan view, the sensor pixel is positioned between two adjacent ones among the plurality of data integrated circuits in an arrangement direction of the plurality of data integrated circuits.

8. The display device according to any one of claims 1 to 7, wherein the data driver is arranged to continuously provide the sensor data signal of a voltage level corresponding to a maximum grayscale to the sensor data line during a driving period, and to provide the sensor data signal of a voltage level corresponding to a grayscale within a grayscale range to the sensor data line during a sensing period.

9. The display device according to claim 8, wherein
the display panel further includes a reference pixel,
the reference pixel and the sensor pixel include a substantially same characteristic,
the data driver is arranged to provide a reference data signal of a voltage level different from that of the sensor data signal to the reference pixel during the driving period, and to provide a reference data signal of a voltage level equal to that of the sensor data signal to the reference pixel during the sensing period,
the reference data signal in the driving period has a gate-off voltage level substantially turning off a transistor, and
the sensing driver is arranged to measure a current flowing through the reference pixel and to obtain the sensing information corresponding to a difference between the current of the sensor pixel and the current of the reference pixel.

10. The display device according to any one of claims 1 to 9, wherein
the display panel includes a first pixel, a second pixel, a first sensor pixel, and a second sensor pixel,
the first pixel and the second pixel are arranged to emit different color light,
the data driver is arranged to provide a first maximum data voltage of the first pixel to the first sensor pixel and to provide a second maximum data voltage of the second pixel to the second sensor pixel during a driving period, and
the second maximum data voltage is different from the first maximum data voltage.

11. The display device according to any one of claims 1 to 10, further comprising:
a timing controller arranged to predict a deterioration characteristic of the pixel based on the sensing information and is arranged to compensate for image data based on the predicted deterioration characteristic of the pixel, wherein
the sensor pixel further includes auxiliary transistors electrically connected to the sensor transistors in series, respectively,
gate electrodes of the auxiliary transistors are commonly electrically connected to a sensor control line,
the data driver is arranged to generate the data signal based on the compensated image data, and
the timing controller is arranged to provide a sensor control signal to the sensor control line.

12. A display device, comprising:
a display panel including a pixel and a sensor pixel, the pixel including a light emitting element and a driving transistor arranged to control a current flowing through the light emitting element, the sensor pixel including a sensor transistor;
a data driver arranged to supply a data signal to the pixel through a data line and to provide a sensor data signal to the sensor pixel through a sensor data line; and
a sensing driver arranged to obtain sensing information on a current flowing through the sensor pixel, wherein
the sensor transistor and the driving transistor include a substantially same characteristic, and
the sensor pixel does not include a light emitting element.

13. The display device according to claim 12, wherein
the sensor pixel is electrically connected between a first power line and a second power line, and
the sensing driver is arranged to measure a voltage between both ends of a resistor electrically connected to the sensor pixel in series between the first power line and the second power line.

14. The display device according to claim 12 or 13, wherein the data driver is arranged to continuously provide the sensor data signal of a voltage level corresponding to a maximum grayscale to the sensor data line during a driving period, and to provide the sensor data signal of a voltage level corresponding to a grayscale within a grayscale range to the sensor data line during a sensing period.

15. The display device according to claim 14, wherein
the display panel further includes a reference pixel,
the reference pixel and the sensor pixel include a substantially same characteristic,
the data driver is arranged to provide a reference data signal of a voltage level different from that of the sensor data signal to the reference pixel during the driving period, and to provide a reference data signal of a voltage level equal to that of the sensor data signal to the reference pixel during the sensing period,
the reference data signal in the driving period has a gate-off voltage level substantially turning off a transistor, and
the sensing driver is arranged to measure a current flowing through the reference pixel and to obtain the sensing information corresponding to a difference between the current of the sensor pixel and the current of the reference pixel.
